# EUROPEAN PATENT APPLICATION

(11) **EP 2 037 465 A1**
(43) Date of publication of application: **18.03.2009**
(21) Application number: 07116601.1
(22) Date of filing: 17.09.2007
(51) Int. Cl.: H01F 17/00, H03F 1/56, H03H 7/00, H01L 23/522, H01F 27/40

(54) **Double LC-tank structure**

(71) Applicant: Seiko Epson Corporation, Shinjuku-ku Tokyo 163-0811 (JP)
(72) Inventor: Gil Galí, Ignacio c/o EPSON EUROPE ELECTRONICS GmbH, 2. planta 08190 Sant Cugat del Vallés (Barcelona) (ES); Cairo Molins, Josep Ignasi c/o EPSON EUROPE ELECTRONICS GmbH, 2. planta 08190 Sant Cugat del Vallés (Barcelona) (ES); Sieiro Córdoba, Javier José c/o Departament d'Electrònica, 08028 Barcelona (ES); Argemí Ribera, Oriol c/o Departament d'Electrònica, 08028 Barcelona (ES)
(74) Representative: Carpintero Lopez, Francisco

(57) **Abstract**

The present invention refers to an integrated LC-tank structure with improved Radio-Frequency (RF) choke function and optimized geometry, which minimize area consumption and maximize quality factor. The LC-tank is based on a differential transformer and two capacitors connected in parallel with the windings of the transformer. The windings of the transformer are formed by two interlaced multi-turn spiral coils obtained in a semiconductor substrate.

## Description

### OBJECT OF THE INVENTION

It is an object of the present invention to provide an integrated LC-tank structure with improved Radio-Frequency (RF) choke function and optimized geometry, in order to minimize area consumption and maximize quality factor.

The LC-tank is based on a differential transformer and two capacitors connected in parallel with the windings of the transformer.

### BACKGROUND OF THE INVENTION

Inductive elements such as transformers and inductors in a semiconductor device, require large areas of the semiconductor die. Thus, there is a need for integrated inductive elements of reduced area, that additionally facilitate their electric connection with other components of the integrated circuit.

On the other hand, there is also the need for devices that provide an improved RF choke function, for example for its use in Low Noise Amplifiers, Power Amplifiers, etc.

### SUMMARY OF THE INVENTION

An aspect of the invention refers to a LC-tank structure comprising a transformer having a first and a second coupled windings shaped as spiral coils. A first spiral coil is connected in parallel with a first capacitor to form a first LC tank, and the second spiral coil is connected in parallel with a second capacitor to form a second LC tank. The structure comprises only three connection ports, since the first LC tank is connected between a first port and a third port, and the second LC tank is connected between a second port and said third port of the structure. Then two LC-tanks are implemented in the same structure having only three connection ports.

Preferably, the transformer has an octagonal geometry and the three (input/output) ports are located at the same corner, in order to facilitate the connection of the structure, particularly when the structure is located at a corner of a semiconductor die.

This distribution reduce area consumption of the semiconductor die, if the inductors are located in the chip corners. Additionally, this configuration allows a good reject level at the notch frequency, which can be controlled by means of the value of the equivalent inductance of the transformer and the capacitance.

Compared with conventional inductors, the structure of the invention obtains better results than conventional LC tanks, since the trafo geometry is optimized in order to minimize area, maximize quality factor and because of the double LC tank performance which allows achieving a higher level of rejection at the central frequency tank.

### DESCRIPTION OF THE DRAWINGS

The features of the invention will be better understood by reference to the accompanying drawings, which illustrate preferred embodiments of the invention.
Figure 1.- shows the topology of the differential transformer used in the present invention.
Figure 2.- shows the topology of the differential transformer with two capacitors connected with the connection ports of the structure.

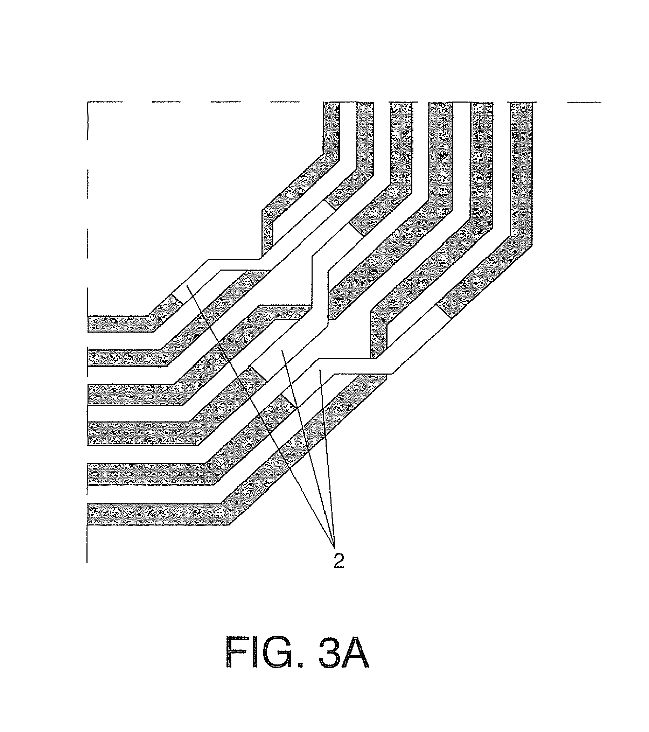

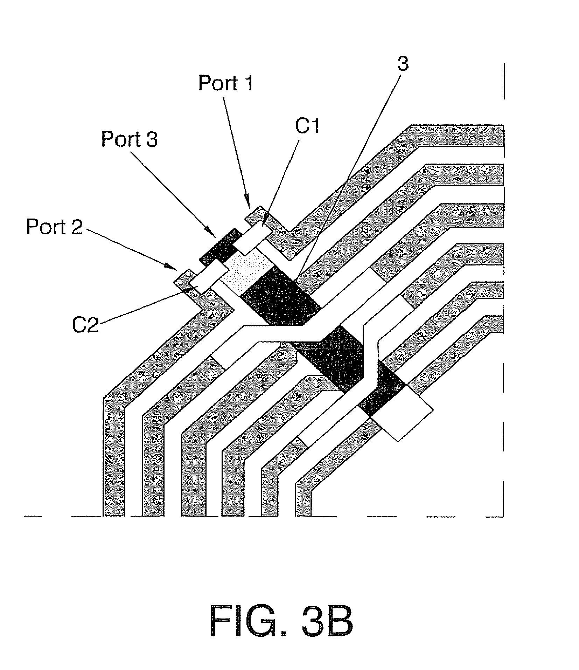

Figure 3.- figure (a) is an enlarged view of the bottom right corner of figure 2, and figure (b) is an enlarged view of the top left corner of figure 2.
Figure 4.- figure (a) shows the electric circuit used for the electromagnetic-electrical cosimulation of the LC tank structure of figure 2, and figure (b) shows the insertion losses results of the simulation.
Figure 5.- figure (a) shows the electrical equivalent circuit of the proposed LC tank, and figures (b) and (c) show the results of the simulated insertion losses obtained respectively between ports (2,1) and (3,1).

### DETAILED DESCRIPTION OF PREFERRED EMBODIMENTS

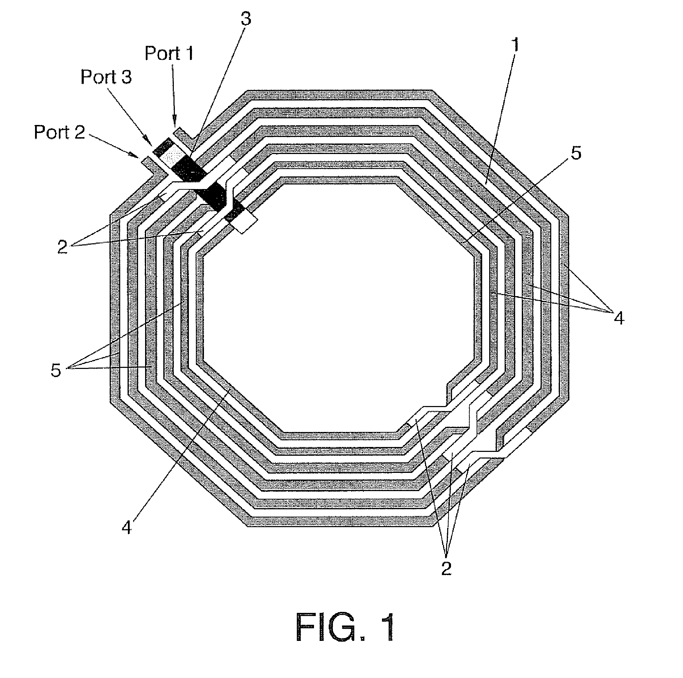

Figure 1 shows the topology of a preferred embodiment of the differential transformer of the present invention. The transformer has an octagonal geometry and presents 3 ports. All the ports (input/output) are located in the same corner of the octagonal shape forming 45° degrees. This geometry and arrangement of the connection ports, reduces area consumption of the structure and improves routing if it is located in the corner of a chip.

The transformer of the LC-tank structure, is implemented by three metal layers located at different levels in a semiconductor substrate and connected by vias. In figure 1, the two windings of the transformer are formed by a first metal layer (1) arranged at certain level of a semiconductor substrate, said metal layer (1) consisting of two alternated multi-loop strips arranged to define an octagonal shape.

In order embodiments, the transformer may have other polygonal shapes.

A second metallization layer (2) is located at different level than metal layer (1), and consist of several strips of metal that serve as bridges to connect several loops of the first metal layer (1). A third metal layer (3) at different level, is a strip arranged transversally to the loops of the first metal layer (1) and it is connected to some of the loops of said first metal (1). The three metallization layers are suitably connected by vias (not shown).

More in detail, a first winding of the transformer is defined by a first multi-turn spiral loop or coil (4) formed in the first metallization layer (1) between Port 1 and Port 3, which is formed by the third metallization layer (3). A second winding of the transformer is defined by a second multi-turn spiral loop or coil (5) of the first metallization layer connected between Port 2 and Port 3, so that the coils of both windings are interlaced by means of the bridges of the second metallization layer (2) as shown in figure 1.

Port 1 is a free end of said first coil (4), and similarly Port 2 is a free end of the second coil (5). Port 3 is the center tap of the transformer because it is connected to the center point of the transformer, since the first and the second coils (4,5) have substantially the same length.

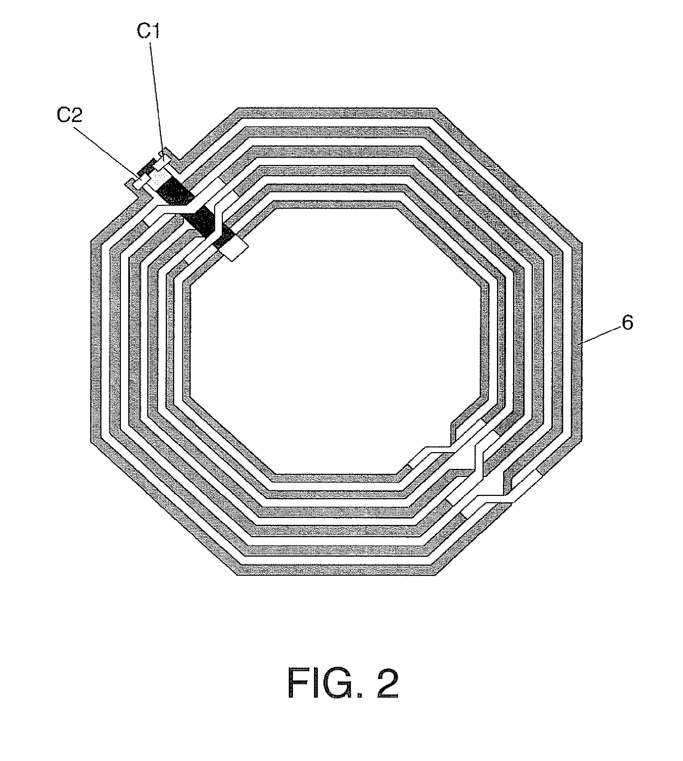

As shown in figure 2, the first and the second coils (4,5) are concentric, and their respective sides are parallel.

The LC tank structure comprises a first capacitor (C1) connected between Ports 1 and 3, and a second capacitor (C2) connected between Ports 2 and 3. Consequently, the first capacitor (C1) is connected in parallel with the first coil (4) so that a first LC-tank is formed between Ports 1 and 3, and the second capacitor (C2) is connected in parallel with the second coil (5) so that a second LC-tank is formed between Ports 2 and 3. Port 3 is the common port of the structure, and it is located in between Ports 1 and 2.

As it can be observed for instance in figure 2, the coils of the first metallization layer (1) define an outer perimeter (6) having an octagonal shape in this particular embodiment. The three ports and the first and the second capacitors (C1,C2), are located in the same side of the octagonal shape at substantially 90 degrees in respect to one side of the octagonal shape. The three ports and located outside said outer perimeter (6).

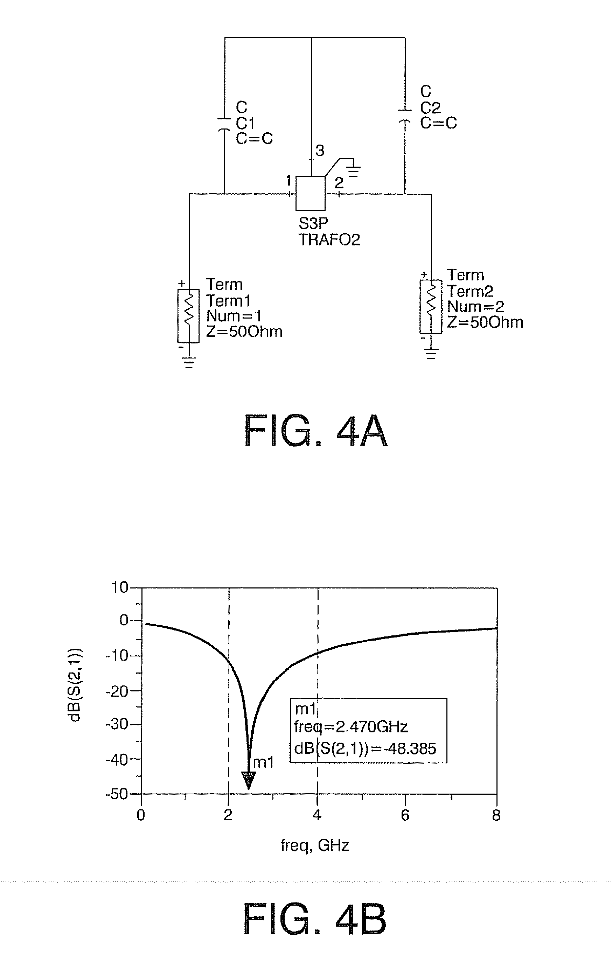

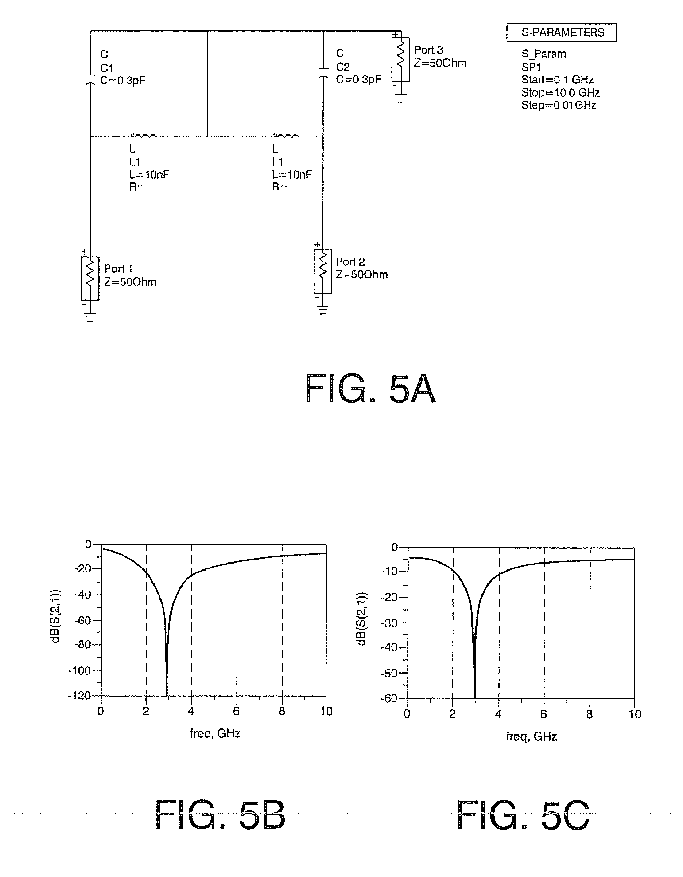

Figure 4 show the electric circuit used for the electromagnetic (with regard to differential transformer) and electrical (with regard to capacitances) cosimulation. Simulated insertion losses results present a good rejection level in the central frequency of the LC resonance in the order of -50dB. Figure 5(a) shows the electrical equivalent circuit of the proposed LC tank, whereas the results of the evaluation obtainedrespectively between ports (2,1) and (3,1), are shown in figures 5(a),(b). The values of the first and the second LC-tanks, are calculated to provide a high choke function at the desired operation frequency.

The LC-tank of the invention may be advantageously used in differential circuits, such as differential Low Noise Amplifiers, wherein a LC-tank is needed for each branch of the differential LNA.

Other embodiments of the invention are described in the attached dependent claims.

## Claims

1. A LC-tank structure comprising a transformer having a first and a second coupled windings, formed respectively by a first spiral coil (4) and a second spiral coil (5) supported by a semiconductor substrate, wherein said first and second coils (4,5) are interlaced, and wherein the first spiral coil (4) is connected in parallel with a first capacitor (C1) to form a first LC tank, and the second spiral coil (5) is connected in parallel with a second capacitor (C2) to form a second LC tank, wherein the first LC tank is connected between a first port (1) and a third port (3) of the structure, and the second LC tank is connected between a second port (2) and said third port (3) of the structure.

2. LC-tank structure according to claim 1 wherein the first and the second spiral coils of the transformer define a polygonal, circular or eliptical shape, having an outer perimeter.

3. LC-tank structure according to claim 1 wherein the first and the second spiral coils of the transformer define an octagonal shape having an outer perimeter.

4. LC-tank structure according to any of the preceding claims wherein the first, second and third ports are located outside said outer perimeter.

5. LC-tank structure according to claim 3 wherein the three ports extend outwards from the same side of the octagonal shape.

6. LC-tank structure according to any of the claims 3 or claim 4 wherein the three ports are arranged substantially at 90 degrees in to one side of the octagonal shape.

7. LC-tank structure according to any of the preceding claims wherein said first and second capacitors are located outside said outer perimeter.

8. LC-tank structure according to claim 5 wherein the port 3 is arranged in between ports 1 and 2.

9. LNA including a LC-tank structure according to any of the preceding claims.
